# EUROPÄISCHE PATENTSCHRIFT

(11) **EP 0 405 246 B1**
(45) Veröffentlichungstag und Bekanntmachung des Hinweises auf die Patenterteilung: **20.07.1994**
(21) Anmeldenummer: 90111290.4
(22) Anmeldetag: 15.06.1990
(51) Int. Cl.: G03F 7/021, G03F 7/012

(54) **Lichtempfindliches Gemisch und daraus hergestelltes Aufzeichnungsmaterial**
Light-sensitive mixture and registration material prepared thereof
Mélange photosensible et matériel pour l'enregistrement préparé à partir de ce mélange

(30) Priorität: 21.06.1989 DE 3920228
(43) Veröffentlichungstag der Anmeldung: 02.01.1991
(73) Patentinhaber: HOECHST AKTIENGESELLSCHAFT, 65926 Frankfurt am Main (DE)
(72) Erfinder: Müller-Hess, Waltraud, Dr., D-6200 Wiesbaden (DE); Mohr, Dieter, Dr., D-6501 Budenheim (DE); Kroggel, Matthias, Dr., D-6233 Kelkheim (DE)

(56) Entgegenhaltungen:
- EP-A- 0 274 075
- EP-A- 0 351 628
- DE-A- 3 639 757
- US-A- 3 660 097

## Beschreibung

Die Erfindung betrifft ein in wäßrigen Lösungen entwickelbares lichtempfindliches Gemisch, das ein polymeres Bindemittel und eine lichthärtbare Verbindung oder Verbindungskombination enthält und das zur Herstellung von lichtempfindlichen Aufzeichnungsmaterialien, insbesondere von Flachdruckplatten und Photoresists geeignet ist.

Aus der DE-A 20 24 244 (= US-A 3 867 147) ist es bekannt, lichtempfindliche Aufzeichnungsmaterialien aus Mischkondensationsprodukten von kondensationsfähigen Diazoniumsalzen und anderen nicht lichtempfindlichen kondensationsfähigen Verbindungen, gegebenenfalls in Kombination mit polymeren Bindemitteln, zur Herstellung von Druckplatten zu verwenden. Diese lichtempfindlichen Materialien zeichnen sich durch hohe Lichtempfindlichkeit und gute Druckauflagen aus. Die Auflage ist besonders hoch bei Verwendung von wasserunlöslichen Bindemitteln, z. B. Polyvinylformal, doch lassen sich solche Schichten nur mit solchen Entwicklern sauber verarbeiten, die einen erheblichen Anteil an flüchtigen organischen Lösemitteln enthalten. Aus ökologischen Gründen ist man bestrebt, die Entwicklung von Druckplatten mit rein wäßrigen Lösungen zu erreichen. Im günstigsten Fall können solche Platten mit relativ aggressiven sauren oder alkalischen rein wäßrigen Lösungen entwickelt werden, indem die Nichtbildbereiche der Schicht in Form von Fladen oder kleineren Partikeln im Entwickler suspendiert werden. Dabei besteht die Gefahr, daß sich solche Partikel unkontrolliert an Nichtbildstellen der Platte redeponieren und diese unbrauchbar machen.

Aus der EP-A 152 819 sind lichtempfindliche Gemische aus Diazoniumsalz-Polykondensationsprodukten und Carboxylgruppen enthaltenden Bindemitteln bekannt, die durch Umsetzen von Hydroxylgruppen enthaltenden Polymeren mit Säureanhydriden erhalten worden sind. Diese Gemische lassen sich mit wäßrig-alkalischen Lösungen entwickeln und sind zur Herstellung von Flachdruckformen hoher Auflagenleistung geeignet. Eine weitere Auflagensteigerung dieser Gemische ist jedoch erwünscht. Es wird deshalb in dieser Druckschrift empfohlen, andere Polymere, z. B. Polyurethane, zur Erhöhung der Abriebbeständigkeit in kleinerer Menge zuzusetzen. Diese Kombination führt jedoch zu kopiertechnischen Nachteilen, z. B. zu einer unerwünschten Tonwertzunahme. Auch wird dadurch die Entwickelbarkeit und die Lagerstabilität beeinträchtigt. Diese Gemische haben außerdem - ebenso wie andere Gemische mit Carboxylgruppen enthaltenden Bindemitteln - den Nachteil, daß sie bei der Verarbeitung mit Entwicklern auf Basis von Leitungswasser zur Ausfällung schwerlöslicher Calciumsalze neigen, die sich in den Entwicklungsmaschinen absetzen und zu Störungen führen.

Aus der US-A 3 660 097 und der DE-A 27 39 774 sind Gemische der angegebenen Gattung bekannt, in denen Polyurethane als polymere Bindemittel Verwendung finden. Der Nachteil dieser Gemische besteht darin, daß die Bindemittel in den üblichen Beschichtungslösemitteln schlecht löslich sind und die Lösungen zur Entfernung von unlöslichen Rückständen mehrfach filtriert werden müssen. Die wäßrig-alkalische Entwickelbarkeit dieser Gemische ist sehr begrenzt und die erzielbare Druckauflage für einen Hochleistungsbereich nicht ausreichend.

Aus der EP-A 0 030 001 ist ein ähnliches Gemisch bekannt, welches als Bindemittel ein verzweigtes Polyurethan enthält. Obwohl mit Hilfe dieses Gemisches relativ hohe Druckauflagen erreichbar sind, weist es ebenfalls einige Nachteile auf. Beispielsweise sind für eine schleierfreie, zügige Entwicklung der lichtgehärteten Schicht bevorzugt saure wäßrige Entwicklerlösungen zu verwenden, die noch organische Lösemittel enthalten. Diese Entwickler können außerdem bei maschineller Verarbeitung zu Korrosionsproblemen der Leichtmetallteile der Entwicklermaschinen führen.

In der EP-A 167 963 wird ein negativ arbeitendes lichtempfindliches Gemisch beschrieben, das zur Herstellung von Flachdruckplatten geeignet ist und das ein Diazoniumsalz-Polykondensationsprodukt, eine radikalisch polymerisierbare ethylenisch ungesättigte Verbindung, einen Photoinitiator und ein wasserunlösliches polymeres Bindemittel enthält. Hohe Druckauflagen werden dabei mit Polyvinylacetalen als Bindemittel erzielt, wobei aber zur Entwicklung Lösungen erforderlich sind, die vorwiegend aus organischen Lösemitteln bestehen.

In der EP-A 274 075 werden lichthärtbare Gemische beschrieben, die eine lichthärtbare Substanz und ein Polyvinylacetal enthalten, das durch Umsetzen von Vinylalkoholpolymeren mit Hydroxygruppen enthaltenden Aldehyden erhalten worden ist. Diese Gemische, die zur Herstellung von Flachdruckplatten und Photoresists geeignet sind, lassen sich mit neutralen oder schwach alkalischen wäßrigen Lösungen entwickeln. Sie ergeben Flachdruckplatten mit relativ hoher Auflagenleistung, jedoch ist die Auflage niedriger als sie mit Gemischen erreicht wird, die nicht mit rein wäßrigen Lösungen entwickelt werden können.

In der DE-A 37 32 089 werden Pfropfpolymerisate beschrieben, die aus einem Polyurethan als Pfropfgrundlage und aufgepfropften Vinylestereinheiten bestehen, die mindestens teilweise zu Vinylalkoholeinheiten verseift sind. Die Polymeren werden als Bindemittel für Pigmente, zur Herstellung von Druckfarben, von Schmelzklebern, von lösemittelhaltigen Klebstoffen, als Bestandteil von Lacken oder Beschichtungsmitteln für Fasern, Folien und Metalle und für thermoplastische Formkörper eingesetzt.

In der JP-A 246047/87 werden photopolymerisierbare Gemische beschrieben, die als Bindemittel Pfropfmischpolymerisate aus Polyurethanen und Polyvinylalkohol mit Mercaptogruppen enthalten.

In der älteren deutschen Patentanmeldung P 38 35 840.9 werden Pfropfpolymerisate beschrieben, die aus den in der DE-A 37 32 089 beschriebenen Pfropfpolymerisaten durch Acetalisieren mit Aldehyden erhalten werden.

In der älteren deutschen Patentanmeldung P 38 24 146.3 werden lichthärtbare elastomere Gemische beschrieben, die eine radikalisch polymerisierbare Verbindung, einen Photoinitiator und als Bindemittel ein in Wasser oder einer wäßrigen Lösung lösliches oder dispergierbares Pfropfpolymerisat gemäß der DE-A 37 32 089 enthalten.

Aufgabe der Erfindung war es, ein lichtempfindliches Gemisch vorzuschlagen, das für die Herstellung von Druckplatten, insbesondere Flachdruckplatten, oder von Photoresists geeignet ist, das alle Vorzüge der bekannten lichtempfindlichen Gemische aufweist, das sich mit praktisch lösemittelfreien wäßrigen Lösungen entwickeln läßt, ohne bei der Verarbeitung mit Leitungswasser enthaltenden Entwicklerlösungen störende Abscheidungen zu ergeben, und das zugleich Druckplatten mit hoher Lichtempfindlichkeit, guter Bildauflösung, hoher Auflage und guter Farbannahme sowie mit hoher Lagerfähigkeit ergibt, wie sie bisher nur mit solchen Druckplatten erreichbar waren, die zur Entwicklung den Zusatz von größeren Mengen organischer Lösemittel erforderten.

Erfindungsgemäß wird ein lichtempfindliches Gemisch vorgeschlagen, das als wesentliche Bestandteile eine lichthärtbare Verbindung oder Verbindungskombination und ein polymeres Bindemittel mit wiederkehrenden Vinylacetaleinheiten enthält.

Das erfindungsgemäße Gemisch ist dadurch gekennzeichnet, daß das Bindemittel ein Pfropfmischpolymerisat mit einem Polyurethan als Pfropfgrundlage ist, das aufgepfropfte Ketten mit Vinylalkoholeinheiten und von Hydroxyaldehyden abgeleiteten Vinylacetaleinheiten trägt.

Erfindungsgemäß wird ferner ein lichtempfindliches Aufzeichnungsmaterial aus einem Schichtträger und einer lichtempfindlichen Schicht vorgeschlagen, das dadurch gekennzeichnet ist, daß die lichtempfindliche Schicht aus dem vorstehend definierten Gemisch besteht.

Die in dem erfindungsgemäßen Gemisch enthaltenen Pfropfmischpolymerisate sind neu. Zu ihrer Herstellung wird auf eine Pfropfgrundlage aus einem Polyurethan ein Carbonsäurevinylester und ggf. eine weitere damit copolymerisierbare ethylenisch ungesättigte Verbindung aufgepfropft und danach ganz oder teilweise verseift. Die dabei erhaltenen Polymeren mit Vinylalkoholeinheiten, die aus der DE-A 37 32 089 bekannt sind, werden weiter mit Hydroxyaldehyden zu den neuen Polyvinylacetalen umgesetzt.

Der Mengenanteil der aufgepfropften Komponenten beträgt im allgemeinen 10 bis 95, vorzugsweise 30 bis 90 und insbesondere 40 bis 80 Gew.-%, bezogen auf das gesamte Pfropfpolymerisat.

Die Pfropfgrundlagen bestehen aus Polyurethanen mit mindestens zwei Urethangruppen im Molekül, wobei die Anzahl der Urethangruppen pro Molekül nach oben keiner besonderen Begrenzung unterliegt und im allgemeinen höhere Werte als 2 hat.

Die als Pfropfgrundlage eingesetzten Polyurethane lassen sich nach üblichen Verfahren der Polyurethansynthese aus Diolen und Diisocyanaten herstellen. Prinzipiell sind alle bei der Polyurethansynthese üblicherweise verwendeten Diole einsetzbar. Bevorzugt werden cycloaliphatische Diole, wie Cyclohexandiole, sowie insbesondere aliphatische Diole mit 2 bis 12 C-Atomen. Bevorzugt werden ferner Polyetherdiole, z. B. Polypropylenoxide, Polybutylenoxide, Mischpolymere aus Ethylenoxid, Propylenoxid, Butylenoxid, vorzugsweise deren Blockcopolymere, oder Poly-1,4-butandiole; besonders bevorzugt werden Polyethylenoxide, insbesondere solche mit Molekulargewichten zwischen 200 und 10 000, insbesondere zwischen 400 und 1500. Die Polyetherdiole werden mit Vorteil in Kombination mit niedermolekularen aliphatischen Diolen, z. B. 1,4-Butandiol, 1,3-Propandiol, Ethylenglykol, Diethylenglykol, 1,2-Hexandiol, 1,2-Propandiol, Pentandiol oder Cyclohexandiol eingesetzt. Bevorzugt liegt ein molares Verhältnis von Polyetherdiol zu niedermolekularem aliphatischem Diol von 1 : 0,1 bis 1 : 0,7 vor.

Als Diisocyanatkomponenten können aromatische Diisocyanate eingesetzt werden. Bevorzugt werden aliphatische und/oder cycloaliphatische Diisocyanate. Bevorzugte aliphatische Diisocyanate sind solche mit 2 bis 12 C-Atomen im aliphatischen Rest, z. B. Ethylendiisocyanat, Propylendiisocyanat, Tetramethylendiisocyanat, 2,2,4-Trimethyl-hexamethylendiisocyanat. Bevorzugte cycloaliphatische Diisocyanate sind z. B. 1,4-Diisocyanato-cyclohexan, Dicyclohexylmethan-4,4′-diisocyanat und Isophorondiisocyanat. Besonders bevorzugt werden Hexamethylendiisocyanat und Isophorondiisocyanat.

Das Molverhältnis von Diol- zu Diisocyanatkomponente liegt vorzugsweise zwischen 1 : 0,99 und 1 : 0,5, insbesondere zwischen 1 : 0,98 und 1 : 0,7. Die mittleren Molekulargewichte der Polyurethane liegen vorzugsweise zwischen 200 und 100 000, insbesondere zwischen 1 000 und 50 000, besonders bevorzugt zwischen 3 000 und 25 000.

Zum Pfropfen auf das Polyurethan werden Carbonsäurevinylester mit 3 bis 20, vorzugsweise 4 bis 14 C-Atomen eingesetzt. Besonders bevorzugt werden Vinylacetat und/oder Vinylpropionat, insbesondere Vinylacetat. Bevorzugt werden ferner Gemische aus Vinylacetat und/oder Vinylpropionat und Vinylversatat. Insbesondere bei Teil- oder Vollverseifung der Produkte im Anschluß an die Pfropfpolymerisation ist beim Pfropfen die Mitverwendung von Vinylpropionat neben Vinylacetat vorteilhaft. Außerdem lassen sich copolymerisierbare Gemische aus Vinylcarbonsäureestern pfropfen, vorzugsweise Gemische aus Vinylacetat und kleineren Mengen Vinylversatat.

Auch das Pfropfen mit verschiedenen Carbonsäurevinylestern in Form von Blockcopolymeren, gegebenenfalls in Kombination mit weiteren ethylenisch ungesättigten und copolymerisationsfähigen Monomeren, kann vorteilhaft sein. Weiterhin können die Carbonsäurevinylester auch zusammen mit anderen ethylenisch ungesättigten und copolymerisierbaren Monomeren, insbesondere Säuren, wie Maleinsäure, Itaconsäure, Mesaconsäure, Crotonsäure, Acrylsäure, oder deren Estern, gepfropft werden.

Die erhaltenen Pfropfpolymerisate lassen sich durch Hydrolyse, Alkoholyse oder Umesterung in teil- oder vollverseifte Produkte überführen, wobei der Hydrolysegrad mindestens 30 mol-%, vorzugsweise 45 bis 99 mol-%, bezogen auf die Molzahl verseifbarer Monomereinheiten im Pfropfpolymerisat, beträgt. Die Herstellung der Pfropfpolymerisate mit Polyurethan-Pfropfgrundlage ist in der DE-A 37 32 089 beschrieben.

Die verseiften Pfropfpolymerisate lassen sich im sauren Medium nach an sich bekannten Methoden acetalisieren. Zur Acetalisierung werden aliphatische C₂- bis C₂₀-Hydroxyaldehyde, die substituiert sein können, eingesetzt. Bevorzugt werden Aldehyde einer der Formeln I und II

HO - R¹- CHO (I)

und 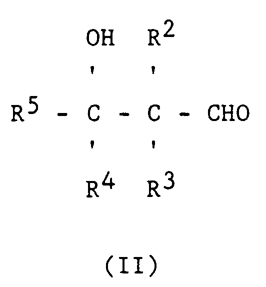
worin
- R¹: eine substituierte oder unsubstituierte Alkylengruppe mit 1 bis 6 Kohlenstoffatomen ist,
- R² und R³: gleich oder verschieden sind und Wasserstoffatome, Alkylreste mit 1 bis 6 Kohlenstoffatomen, Alkoxyreste mit 1 bis 4 Kohlenstoffatomen, Hydroxyalkylreste mit 1 bis 3 Kohlenstoffatomen oder Hydroxygruppen bedeuten,
- R⁴: ein Wasserstoffatom oder ein Alkylrest mit 1 bis 6 Kohlenstoffatomen,
- R⁵: ein Wasserstoffatom, ein Alkyl-, Hydroxyalkyl-oder Alkoxyalkylrest mit 1 bis 6 Kohlenstoffatomen oder ein substituierter oder unsubstituierter Arylrest mit 6 bis 10 Kohlenstoffatomen ist.

Geeignete Hydroxyaldehyde sind in der EP-A 274 075 beschrieben.

In den Verbindungen der Formeln I und II haben die Symbole bevorzugt die folgende Bedeutung:
- R¹: kann als Substituenten insbesondere Halogenatome oder Alkoxygruppen enthalten und hat insgesamt 1 bis 6, bevorzugt 2 bis 5 Kohlenstoffatome.
- R² und R³: sind vorzugsweise Wasserstoffatome, Alkylreste mit 1 bis 4 Kohlenstoffatomen oder Hydroxymethylreste.
- R⁴: ist bevorzugt ein Wasserstoffatom.
- R⁵: ist bevorzugt ein Wasserstoffatom oder ein Alkylrest mit 1 bis 4 Kohlenstoffatomen, ein Hydroxyalkyl- oder Alkoxyalkylrest mit 1 bis 4 Kohlenstoffatomen.

Die Hydroxyaldehyde der Formeln I und II enthalten mindestens eine und bis zu drei, vorzugsweise bis zu 2 Hydroxygruppen.

Unter den Hydroxyaldehyden werden die Selbstkondensationsprodukte des Acetaldehyds und seiner höheren Homologen sowie die Kondensationsprodukte von Acetaldehyd mit Propionaldehyd oder höheren aliphatischen Aldehyden sowie 4-Hydroxybutanal und 5-Hydroxypentanal bevorzugt.

Neben den Hydroxyaldehyden werden bevorzugt noch aliphatische C₁- bis C₂₀-Aldehyde oder aromatische Aldehyde, die substituiert sein können, eingesetzt. Bevorzugt werden aliphatische Aldehyde mit 1-5 C-Atomen, z. B. n-Butyraldehyd, Isobutyraldehyd, Propionaldehyd oder Acetaldehyd. Ggf. substituierte Benzaldehyde, z. B. Benzaldehyd, p-Chlorbenzaldehyd oder p-Methoxy-benzaldehyd, sind ebenfalls geeignet.

Anstelle der freien Aldehyde können auch die entsprechenden Acetale mit niederen Alkoholen, z. B. 2-Methoxy-acetaldehyddimethylacetal, Brom- oder Chloracetaldehyddiethylacetal oder die Umsetzungsprodukte von Phenolen mit Halogenalkyldialkylacetalen, eingesetzt werden. Die Acetale können unmittelbar oder nach Hydrolyse zum Aldehyd mit dem Polymeren umgesetzt werden.

Die in dem erfindungsgemäßen Gemisch eingesetzten Pfropfmischpolyvinylactale enthalten somit mindestens zwei, vorzugsweise vier verschiedene Typen von Einheiten in den aufgepfropften Seitenketten:
a) Vinylalkoholeinheiten,
b) ggf. Carbonsäurevinylestereinheiten,
c) Vinylacetaleinheiten mit freien OH-Gruppen und
d) ggf. Vinylacetaleinheiten ohne freie OH-Gruppen.

Der Mengenanteil der verschiedenen Einheiten beträgt bei
a) 15 bis 70, bevorzugt 20 bis 50 mol-%,
b) 0 bis 65, bevorzugt 1 bis 50 mol-%,
c) 5 bis 70, bevorzugt 7 bis 65 mol-%,
d) 0 bis 75, bevorzugt 10 bis 70 mol-%.

Die Hydroxylzahl des fertigen Bindemittels sollte im Bereich von 100 bis 800, vorzugsweise von 150 bis 600 liegen.

Die Acetalisierung kann nach zwei Verfahren erfolgen:
Bei der ersten Ausführungsform wird das Pfropfpolymere in einem Alkohol oder Wasser-Alkohol-Gemisch gelöst oder dispergiert, mit einer katalytischen Menge einer anorganischen oder organischen Säure und dem Aldehyd oder Aldehydgemisch versetzt und erwärmt. Die erhaltene Polymerlösung, die gegebenenfalls ein Antioxydationsmittel enthält, kann direkt zur Herstellung der erfindungsgemäßen Gemische eingesetzt werden, oder das Polymere kann durch Eintropfen in einen Nichtlöser ausgefällt und gereinigt werden.

Bei der zweiten Ausführungsform wird das Pfropfpolymere in Wasser oder einem Wasser-Alkohol-Gemisch gelöst und mit dem Aldehyd oder Aldehydgemisch versetzt. Dann wird bei niedriger Temperatur, vorteilhaft zwischen -10 °C und Raumtemperatur, eine wäßrige Lösung einer anorganischen oder starken organischen Säure, gegebenenfalls unter Zusatz eines Netzmittels und eines Antioxydationsmittels zugetropft. Dabei fällt das acetalisierte Pfropfpolymere häufig aus. Die Reaktion wird bei erhöhter Temperatur (etwa 20 - 60 °C) vervollständigt. Das isolierte Polymere wird durch Waschen mit Wasser oder durch Umfällen gereinigt. Das zweite Verfahren führt zu einheitlicheren Produkten.

Zur Herstellung der Pfropfpolyvinylacetale in wäßrigem Medium werden nach bekannten Methoden vorzugsweise 1 bis 50, insbesondere 5 bis 20 gew.-%ige, wäßrige Lösungen der Pfropfpolyvinylalkohole vorzugsweise in der Wärme hergestellt, der Säurekatalysator zugesetzt, die Lösungen anschließend auf Temperaturen unterhalb 25 °C abgekühlt und die Acetalisierungsreaktion durch Zudosieren des Aldehyds, vorzugsweise innerhalb von 3 bis 300 Minuten, unter starkem Rühren durchgeführt. Wegen des bekanntermaßen meist nicht vollständigen Aldehydumsatzes wird im allgemeinen mit Aldehydüberschuß, bevorzugt 10 bis 20 mol-%igem Überschuß, gearbeitet.

In einer bevorzugten Verfahrensvariante wird die wäßrige Lösung vor dem Reaktionsbeginn bei Temperaturen von 0 bis 5 °C mindestens 30 Minuten stehengelassen und dann in Gang gesetzt, wonach sich das gebildete Pfropfpolyvinylacetal alsbald meist pulverförmig abscheidet. Zur Vervollständigung der Reaktion wird das Reaktionsgemisch langsam auf Raumtemperatur erwärmt, und es wird gegebenenfalls eine ca. 1 bis 3 Stunden dauernde Nachreaktion bei höheren Temperaturen, z. B. bei 25 bis 70 °C, angeschlossen. Die zu verwendende Menge Säurekatalysator richtet sich u. a. nach dem angestrebten Acetalisierungsgrad und kann vorzugsweise bis zu 1,1 mol, bezogen auf den molaren Gehalt an Vinylalkoholeinheiten, betragen.

Das gebildete Pfropfpolyvinylacetal wird abgesaugt, mit schwach alkalisch eingestelltem Wasser (pH 9 bis 12) gewaschen und getrocknet. Acetalisierungsprodukte, die sich aus der wäßrigen Reaktionslösung nicht abscheiden, können nach Zusatz von Fällungsmitteln isoliert, gereinigt und getrocknet werden.

Die Acetalisierung kann auch in organischen Lösemitteln durchgeführt werden. Als Lösemittel eignen sich mit Wasser mischbare Lösemittel, insbesondere wasserlösliche Alkohole, z. B. Ethanol und/oder Methanol, ggf. unter Zusatz von Wasser.

Als Säurekatalysatoren werden vorzugsweise organische Sulfonsäuren, z. B. Toluolsulfonsäuren, ferner Mineralsäuren, z. B. Schwefelsäure, Phosphorsäure, Salzsäure oder gegebenenfalls Salpetersäure, verwendet. Phosphorsäure und Salzsäure werden bevorzugt.

Zur Herstellung in organischen Lösemitteln werden der Säurekatalysator, der Aldehyd und der Pfropf-Polyvinylalkohol in dem Lösemittel dispergiert oder gelöst und das Gemisch unter Rückfluß erhitzt. Gegebenenfalls kann der Aldehyd auch während des Reaktionsverlaufs zudosiert werden. Die in dem organischen Lösemittel unlöslichen Pfropf-Polyvinylalkohole gehen dabei mit fortschreitender Acetalisierung in Lösung.

Nach Beendigung der Acetalisierungsreaktion wird das Reaktionsprodukt durch Zusatz von unpolaren Lösemitteln, z. B. aliphatischen Kohlenwasserstoffen, oder durch Eingießen der Reaktionslösung in eiskaltes Wasser bzw. eiskaltes Wasser-Alkohol-Gemisch ausgefällt, abgesaugt, mit schwach alkalisch eingestelltem Wasser (pH 9 bis 12) gewaschen und getrocknet.

Die derart erhältlichen Polymeren ergeben in Kombination mit unterschiedlichen negativ arbeitenden lichtempfindlichen Substanzen, wie Diazoniumsalz-Polykondensationsprodukten, Azidoverbindungen, p-Chinondiaziden oder photopolymerisierbaren Gemischen aus polymerisierbaren Verbindungen und Photoinitiatoren leicht und schleierfrei entwickelbare Schichten, die je nach Art der Zusammensetzung mit Wasser, wäßrigen Lösungen von anorganischen Salzen und/oder Tensiden oder mit wäßrig-alkalischen Lösungen entwickelt werden können. Die Schichten zeichnen sich durch hohe Abriebbeständigkeit, gute Farbannahme und praxisgerechte Lagerstabilität aus und sind daher für zahlreiche Anwendungsmöglichkeiten einsetzbar, insbesondere für die Herstellung von Flachdruckplatten, Siebdruckschablonen und Photoresists.

Die lichtempfindlichen Gemische enthalten im allgemeinen 20 bis 90, bevorzugt 30 bis 75 Gew.-% polymeres Bindemittel, bezogen auf das Gewicht aller nichtflüchtigen Bestandteile des Gemischs. Bis zu 50, vorzugsweise bis zu 20 Gew.-%, der Gesamtmenge an Bindemittel können durch herkömmliche Bindemittel ersetzt werden.

Als lichthärtbare Verbindungen sind insbesondere Diazoniumsalz-Polykondensationsprodukte, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten A-N₂X noch andere, nicht lichtempfindliche Einheiten B enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten A-N₂X leiten sich bevorzugt von Verbindungen der Formel (R¹-R²-)ₚR³-N₂X ab, wobei
- X: das Anion der Diazoniumverbindung,
- p: eine ganze Zahl von 1 bis 3,
- R¹: einen aromatischen Rest mit mindestens einer zur Kondensation mit aktiver Carbonylverbindung befähigten Position,
- R³: eine Arylengruppe, vorzugsweise eine ggf. substituierte Phenylengruppe,
- R²: eine Einfachbindung oder eine der Gruppen:

-(CH₂)_{q}-NR⁴-,

-O-(CH₂)ᵣ-NR⁴-,

-S-(CH₂)ᵣ-NR⁴-,

-S-CH₂CO-NR⁴-,

-O-R⁵-O-,

- O -

- S - oder

-CO-NR⁴-

bedeuten, worin
- q: eine Zahl von 0 bis 5,
- r: eine Zahl von 2 bis 5,
- R⁴: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- R⁵: eine Arylengruppe mit 6 bis 12 C-Atomen ist.

Weitere vorteilhafte Polykondensationsprodukte werden erhalten, indem ein ggf. substituiertes Diphenylamindiazoniumsalz zuerst mit einer aromatischen Verbindung R′-O-CH₂-B und danach mit einer aromatischen Verbindung R′-O-CH₂-B-CH₂-O-R′ kondensiert wird, wobei R′ ein Wasserstoffatom, ein Alkyl- oder aliphatischer Acylrest und B der Rest einer der vorstehend aufgezählten kondensationsfähigen Verbindungen ist. Diese Kondensationsprodukte sind in der EP-A 126 875 beschrieben. Der Mengenanteil an Diazoniumsalz-Polykondensationsprodukten liegt allgemein zwischen 5 und 70, vorzugsweise zwischen 10 und 50 Gew.-%, bezogen auf die nichtflüchtigen Bestandteile des Gemischs.

Für gewisse Anwendungen sind als lichthärtbare Verbindungen auch nieder- oder höhermolekulare Azidoderivate geeignet, wobei niedermolekulare Azidoverbindungen mit mindestens zwei Azidogruppen pro Molekül bevorzugt werden. Als Beispiele seien 4,4′-Diazidostilbene, 4,4′-Diazidobenzophenone, 4,4′-Diazidobenzalacetophenone, 4,4′-Diazidobenzalacetone oder 4,4′-Diazidobenzalcyclohexanone genannt. Die Lichtempfindlichkeit derartiger Azidoverbindungen kann gegebenenfalls durch Verwendung geeigneter Sensibilisatoren, z. B. von 1,2-Benzanthrachinon, verstärkt werden. Weiterhin geeignet sind auch solche polyfunktionellen Azide, deren Eigenabsorption durch Konjugation mit Doppelbindungen im Molekül so verschoben ist, daß keine zusätzliche Sensibilisierung bei der Belichtung erforderlich ist.

Weitere geeignete Azidoverbindungen sind in der GB-A 790 131 , der DE-C 950 618 und der US-A 2 848 328 beschrieben. Der Mengenanteil an Azidoverbindungen liegt im allgemeinen zwischen 5 und 60, vorzugsweise zwischen 10 und 40 Gew.-%, bezogen auf die nicht-flüchtigen Bestandteile des Gemischs.

Zur Stabilisierung des lichtempfindlichen Gemischs mit Diazoniumsalz-Polykondensationsprodukten ist es vorteilhaft, diesem eine Verbindung mit Säurecharakter zuzusetzen. In Betracht kommen Mineralsäuren und starke organische Säuren, wobei Phosphorsäure bevorzugt wird. Die Gemische können ferner Farbstoffe und/oder Pigmente enthalten, die sowohl als Kontrastmittel als auch schichtverfestigend wirken können.

Die erfindungsgemäßen Gemische und Materialien können als lichthärtbare Substanzen auch Kombinationen radikalisch polymerisierbarer Verbindungen mit Photoinitiatoren enthalten. Als polymerisierbare Verbindungen werden bevorzugt Ester der Acryl- oder Methacrylsäure mit ein- oder mehrwertigen, vorzugsweise primären Alkoholen verwendet. Vorzugsweise sollten die polymerisierbaren Verbindungen mehr als eine, insbesondere 2 bis 4, polymerisierbare Gruppen enthalten. Beispiele für geeignete mehrwertige Alkohole sind Ethylenglykol, Propylenglykol, Butandiol-1,4, Butandiol-1,3, Diethylenglykol, Triethylenglykol oder Polyethylen- oder Polypropylenglykole mit Molekulargewichten von etwa 200 bis 1.000, Neopentylglykol, Glycerin, Trimethylolethan und -propan, Pentaerythrit, Bisphenol-A-Derivate sowie Umsetzungsprodukte dieser Verbindungen mit Ethylenoxid und/oder Propylenoxid. Besonders geeignet sind Urethangruppen enthaltende Bisacrylate und Bismethacrylate, die durch Umsetzung von 1 mol eines Diisocyanats mit 2 mol Hydroxyalkylacrylat oder -methacrylat erhalten werden. Das Diisocyanat kann auch ein oligomeres, durch Umsetzen eines Diols mit einem molaren Überschuß an monomerem Diisocyanat erhaltenes Produkt sein. Derartige und ähnliche Urethangruppen enthaltende Monomere sind in den DE-A 20 64 079, 28 22 190, 30 48 502 und 35 40 480 beschrieben. Zusätzlich zu den genannten Estern können auch Amide von Acryl- oder Methacrylsäure eingesetzt werden. Beispiele sind Methylenbis-(meth)acrylamid, Ethylenbis-(meth)acrylamid und m-Xylylenbis(meth)acrylamid.

Der Mengenanteil des Gemischs an Monomeren beträgt im allgemeinen etwa 10 bis 80, vorzugsweise 25 bis 70 Gew.-% der nichtflüchtigen Bestandteile.

Als Photoinitiatoren können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Photoinitiatoren dieser Art sind in den DE-C 20 27 467, 20 39 861, der DE-A 37 28 168, der EP-B 11 786 und der EP-A 220 589 beschrieben. Außerdem können z. B. Hydrazone, Mercaptoverbindungen, Pyrylium- oder Thiopyryliumsalze, Xanthone, Thioxanthone, Benzochinone, Acetophenone, Benzophenone, synergistische Mischungen mit Ketonen oder Hydroxyketonen und Farbstoff-Redoxsysteme eingesetzt werden. Besonders bevorzugt werden Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Ein bevorzugtes Beispiel ist 2-(4-Methoxystyryl)-4,6-bis-trichlormethyl-s-triazin. Diese Verbindungen können mit Vorteil mit photooxydierbaren Farbstoffen, photoreduzierbaren Verbindungen und ggf. weiteren Coinitiatoren kombiniert werden, wie es z. B. in den EP-A 284 939 und 287 817 beschrieben ist.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Die photopolymerisierbaren Gemische können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Die photopolymerisierbaren Gemische können auch mit anderen negativ arbeitenden lichtempfindlichen Verbindungen, insbesondere mit Diazoniumsalz-Polykondensationsprodukten kombiniert werden.

Die Verarbeitung der erfindungsgemäßen Gemische zu lichtempfindlichen Aufzeichnungsmaterialien erfolgt in bekannter Weise durch Beschichten eines Schichtträgers mit einer Lösung des Gemischs und Trocknen zu einer Schicht gewünschter Dicke. Als Schichtträger eignen sich Metalle, aber auch Polyester- oder Celluloseacetatfolien, Perlongaze etc.. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden. Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Bevorzugt wird das Gemisch zur Herstellung von Flachdruckformen verwendet, wobei als Trägermaterial Aluminium bevorzugt wird. Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxydation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der aus den Gemischen erhaltenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch CO₂-Laser, welche bei 10,6 »m emittieren, oder YAG-Laser, die bei 1,06 »m emittieren.

Als Entwicklerlösungen werden Wasser oder neutrale oder alkalische wäßrige Lösungen mit einem pH-Wert im Bereich von 6 bis 14, vorzugsweise 7,5 bis 12, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5, bevorzugt nicht mehr als 2 Gew.-% an mit Wasser mischbaren organischen Lösemitteln enthalten. Bevorzugt werden schwerflüchtige Lösemittel, z. B. araliphatische Alkohole, deren Dampfdruck bei der Handhabung des Entwicklers nicht ins Gewicht fällt. Die Entwicklung kann in bekannter Weise durch Tauchen, Besprühen, Bürsten oder Tamponieren erfolgen. Anschließend kann das entwickelte Material mit einem Konservierungsmittel behandelt werden.

Die erfindungsgemäßen lichtempfindlichen Aufzeichnungsmaterialien weisen gute Wiedergabeeigenschaften und praxisgerechte Lagerstabilität auf. Sie lassen sich leicht und schleierfrei mit Entwicklerlösungen verarbeiten, die praktisch umweltneutral sind. Von besonderem Vorteil ist die hohe Druckauflage, die mit den aus dem erfindungsgemäßen Material hergestellten Druckformen erreicht wird sowie die gute Farbannahme. Die Druckschablonen weisen ebenfalls eine hohe Resistenz gegenüber alkalischen Entwicklern und anderen Verarbeitungslösungen auf.

Das erfindungsgemäße Gemisch erfordert, wenn es eine photopolymerisierbare Kombination enthält, nicht unbedingt einen Sauerstoffausschluß bei der Belichtung. Es ist aber im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Polyvinylalkohol, Vinylalkohol/Vinylacetat-Copolymere, Polyvinylpyrrolidon, Vinylpyrrolidon/Vinylacetat-Copolymere, Polyacrylsäure, Butadien/Maleinsäure-Copolymere, Polyvinylmethylether, Polyphosphate, Zucker usw.. Solche Deckschichten haben im allgemeinen eine Dicke von 0,1 bis 10, vorzugsweise von 0,5 bis 5 »m.

Zur Steigerung der Druckauflage im Falle von photopolymerisierbaren Gemischen kann nach der Belichtung eine Nacherwärmung erfolgen oder die entwickelte Druckplatte nachbelichtet werden. Beide Schritte können auch kombiniert angewendet werden. Ohne Nacherwärmung oder -belichtung werden bereits gute Druckauflagen erreicht.

Auch eine lichtempfindliche Schicht mit anderen lichtempfindlichen Verbindungen, z. B. Diazoniumsalz-Polykondensationsprodukten, kann durch eine thermische Nachbehandlung zusätzlich verfestigt werden, was insbesondere bei der Anwendung als Flachdruckform sinnvoll ist. Zu diesem Zweck wird die konservierte Druckform auf Temperaturen zwischen 180 und 240 °C erwärmt. Die Dauer dieser Behandlung ist abhängig von der Temperatur und schwankt zwischen 2 und 20 Minuten. Diese thermische Nachbehandlung erfordert keinen Zusatz eines Vernetzungsmittels. Es wird angenommen, daß die Pfropfpolyvinylacetale unter diesen Bedingungen Wasser abspalten und in Polymere mit ungesättigten Seitengruppen übergehen, die einer zusätzlichen photochemischen oder thermischen Vernetzung zugänglich sind. Es kann daher sinnvoll sein, dem lichtempfindlichen Gemisch zusätzlich einen thermischen Vernetzer zuzufügen, z. B. ein organisches Peroxid mit einer Scorch-Temperatur von mindestens 100 °C, das oberhalb dieser Temperatur befähigt ist, Radikale zu bilden, wie es in der EP-A 247 461 beschrieben ist. Geeignete Peroxide sind Peroxyester, Peroxyketale, Bisaralkylperoxide, Dialkylperoxide und Bis-dialkylperoxide. Durch diese thermische Nachbehandlung wird das Farbannahmeverhalten der lichtempfindlichen Schicht erheblich verbessert, insbesondere dann, wenn solche Polymeren eingesetzt werden, die eine hohe Hydroxylzahl aufweisen.

Die erfindungsgemäßen Gemische erlauben auch die Herstellung von Resistschablonen ausgezeichneter Auflösung, die eine ausreichende Wärmestandfestigkeit aufweisen und eine ausreichende Lagerstabilität gewährleisten. Auch in diesem Fall können sehr milde, wenig oder nicht toxische Entwicklerlösungen verwendet werden. Schließlich ist als Anwendungsbereich noch die Herstellung von Siebdruckschablonen zu benennen. Auch hier sind als besondere Vorteile wieder die günstige Verarbeitbarkeit und die gute Lagerstabilität des Gemischs zu nennen.

Im folgenden wird zunächst die Herstellung der in den Beispielen eingesetzten Polyvinylacetale beschrieben.

### a) Herstellung von Polyurethan-Pfropfgrundlagen

In einem Reaktionsgefäß mit Rührwerk wurden unter Stickstoffatmosphäre jeweils die Diolkomponente und der Katalysator vorgelegt, und das Gemisch wurde auf eine Reaktionstemperatur zwischen 65 und 100 °C erwärmt. Die Diisocyanatkomponente wurde anschliessend so zudosiert, daß die Temperatur des Reaktionsgemischs 120 °C, vorzugsweise 100 °C, nicht überschritt. Nach vollständiger Zudosierung der Diisocyanatkomponente wurde zur Vervollständigung der Reaktion bis zu zwei Stunden auf 80 bis 100 °C nacherwärmt. Die Vollständigkeit des Umsatzes und damit das Ende der Reaktion wurden durch Analyse des Diisocyanatverbrauchs nach üblichen Methoden (z. B. IR-Spektroskopie, Titration) ermittelt.

Einzelheiten über die Zusammensetzung der Reaktionsgemische der Beispiele sowie das berechnete mittlere Molekulargewicht (M̅_{ber}) der resultierenden Polyurethane (PU) können der Tabelle 1 entnommen werden. Die Molekulargewichte ergeben sich aus dem Molverhältnis Diolkomponente/Diisocyanat unter der Annahme einer vollständigen Umsetzung der NCO-Gruppen.

**Tabelle 1**

| Polyurethan (PU) | Diolkomponente PEG/Bu (Molverhältnis) | Reaktionstemp. °C | Molverhältnis Diolkomponente/Diisocyanat | M̅_{ber} |
|---|---|---|---|---|
| A | 7 : 3 | 80 | 1 : 0,9 | 6470 |
| B | 7 : 3 | 72 | 1 : 0,9 | 6470 |
| C | 3 : 2 | 78 | 1 : 0,97 | 18300 |
| D | 7 : 3 | 75 | 1 : 0,97 | 19900 |
| Alle Produkte wurden mit Isophorondiisocyanat als Diisocyanatkomponente hergestellt. Als Katalysator wurde bei allen Produkten 1,4-Dimethylpiperazin in einer Menge von 0,48 mol-%, bezogen auf Diisocyanat, eingesetzt. PEG = Polyethylenglykol, Molgewicht 600 Bu = 1,4-Butandiol | | | | |

### b) Herstellung der Pfropfpolymeren

Die Polyurethan-Pfropfgrundlage wurde jeweils in einem Reaktionsgefäß unter Stickstoffatmosphäre aufgeschmolzen bzw. unter Zusatz geringer Mengen Methanol gelöst und auf eine Temperatur von etwa 60 bis 100 °C erwärmt. Die zu pfropfenden Monomeren wurden, ggf. gelöst in einem Lösemittel (z. B. Methanol), einschließlich des in den Monomeren gelösten radikalischen Initiators so langsam zu der Polyurethan-Pfropfgrundlage dosiert, daß die Bildung von Homopolymerisat weitgehend unterblieb. Die Temperatur des Reaktionsgemischs sollte 120 °C, besser noch 100 °C nicht überschreiten. Nach Beendigung der Nachreaktion wurde überschüssiges Restmonomeres durch azeotrope Destillation mit Methanol entfernt. Die Zusammensetzung der einzelnen Reaktionsgemische sowie die Reaktionsparameter sind in Tabelle 2 angegeben.

**Tabelle 2**

| Pfropfpolymeres | PU | VAc g/g PU | Start Temp. °C | Zudos-Zeit Min. | Nachreakt. Min. | Gepfr. Monom. Gew.-% | Jₒ ml/g | Berechnetes Mol-Gew. |
|---|---|---|---|---|---|---|---|---|
| AV | A | 4 | 75 | 420 | 45 | 79,8 | 21,9 | 31300 |
| BV | B | 2,32 | 73 | 420 | 45 | 69,3 | 18,3 | 21000 |
| CV | C | 3,16 | 75 | 300 | 45 | 74,7 | 26,3 | 72500 |
| DV | D | 3,16 | 75 | 420 | 45 | 74,5 | 28,7 | 78000 |
| Alle Produkte wurden unter Verwendung von 0,2 mol-% Dibenzoylperoxid (bezogen auf das eingesetzte Monomere) hergestellt. Die Grenzviskositätszahlen wurden im Ostwaldviskosimeter in Tetrahydrofuran bei 25 °C ermittelt, die vermessenen Konzentrationen wurden so gewählt, daß eine Hagenbachkorrektur nicht durchgeführt werden mußte. Die gepfropfte Monomermenge in Gew.-% bezieht sich auf das Gewicht des Gesamtpolymeren. VAc = Vinylacetat Jₒ = Grenzviskositätszahl (intrinsic viscosity) | | | | | | | | |

### c) Verseifung der Pfropfpolymeren

Die Pfropfpolymerisate aus Tabelle 2 wurden innerhalb zwei Stunden bei Raumtemperatur umgeestert bzw. verseift. Hierzu wurden die Produkte zu 50 %iger Lösung in Methanol gelöst und mit methanolischer Natronlauge (10 %ig) versetzt. Es wurden je nach Alkalimenge und dem Pfropfungsgrad des Pfropfpolymerisats polymere Hydrolyseprodukte mit unterschiedlichem Hydrolysegrad erhalten. Die Teilverseifung wurde unter Zusatz von Wasser durchgeführt. Die erhaltenen Gele wurden granuliert, das Granulat mit Methanol gewaschen (ggf. unter Zusatz von Essigsäure zur Neutralisation der Natronlauge) und getrocknet. Die Verfahrensbedingungen und Ergebnisse sind in Tabelle 3 aufgeführt.

**Tabelle 3**

| Pfropfpolyvinylalkohol | Pfropfpolyvinylacetat | mol-% NaOH je Estereinheit | mol-% H₂O je Estereinheit | Hydrolysegrad in % | M_{ber} |
|---|---|---|---|---|---|
| E | AV | 1,92 | 0 | 98,2 | 22 000 |
| F | BV | 5,0 | 0 | 98,9 | 14 000 |
| G | CV | 1,92 | 0 | 98 | 47 000 |
| H | DV | 1,97 | 0 | 98,4 | 44 000 |
| I | CV | 0,5 | 11,13 | 56,5 | 58 000 |

### d) Herstellung der Pfropf-Polyvinylacetale

Die Pfropfpolymerisate aus Tabelle 3 wurden unter leichtem Erwärmen in etwa der achtfachen Menge destillierten Wassers gelöst. Bei Raumtemperatur wurde die entsprechende Menge Aldehyd und eine geringe Menge 2,6-Di-tert.-butyl-4-methyl-phenol zugegeben. Zu dieser Lösung wurde unter gutem Rühren eine Lösung aus einer kleinen Menge Natriumoctylsulfat, 1/3 der Gewichtsmenge des Aldehyds an konzentrierter Salzsäure und Wasser zugetropft. Nach einer Stunde Rühren bei Raumtemperatur wurde auf 40 °C erwärmt und noch 2 Stunden gerührt. Dann wurde nochmals konzentrierte Salzsäure in gleicher Gewichtsmenge wie der Aldehyd zugesetzt und weitere 2 Stunden bei 40 °C gerührt. Nach Abkühlen auf Raumtemperatur wurde die wäßrige Phase vom ausgefallenen Polymeren abdekantiert, das Polymere in Ethanol gelöst und durch Eingießen in einen Überschuß Wasser ausgefällt. Das Polymere wurde im Vakuumtrockenschrank bei 40 °C zur Gewichtskonstanz getrocknet.

**Tabelle 4**

| Pfropfpolyvinylacetal | Pfropfpolyvinylalkohol | Aldehyd | Molverhältnis | OH-Zahl |
|---|---|---|---|---|
| K | E | Prl+4-ClBz | 1 : 2 | 302 |
| L | F | Bul+4-CH₃OBz | 1 : 1 | 416 |
| M | G | Bul+Bu | 1 : 1 | 441 |
| N | H | Acl+Bu | 1 : 1 | 394 |
| O | I | Tri+Bu | 3 : 1 | 551 |
| P | H | Prl+Bz | 1 : 2 | 322 |
| Q | F | Tri+Bu | 1 : 2 | 270 |
| R | G | Tri+Bu | 1 : 3,7 | 187 |
| S | H | Bul+Ac | 1 : 1 | 419 |
| T | E | Tri+Pr | 1 : 2 | 244 |
| Ac = Acetaldehyd Acl = Acetaldol Pr = Propionaldehyd Prl = Propionaldol Bu = Butyraldehyd Bul = Butyraldol Bz = Benzaldehyd 4-CH₃OBz = 4-Methoxy-benzaldehyd 4-ClBz = 4-Chlor-benzaldehyd Tri = Triglinaldehyd (3-Hydroxy-pentanal) | | | | |

Die folgenden Beispiele erläutern bevorzugte Ausführungsformen der Erfindung. Die Mengen sind zumeist in Gewichtsteilen (Gt) angegeben. Prozentangaben und Mengenverhältnisse sind in Gewichtseinheiten zu verstehen, wenn nichts anderes angegeben ist.

### Beispiel 1

Eine Beschichtungslösung aus
3,9 Gt des Polymeren N,
1,3 Gt eines Diazoniumsalz-Polykondensationsprodukts aus 1 mol 3-Methoxy-diphenylamin-4-diazoniumsulfat und 1 mol 4,4′-Bis-methoxymethyldiphenylether, isoliert als Mesitylensulfonat,
0,06 Gt Phosphorsäure (85 %ig),
0,02 Gt Phenylazodiphenylamin und
0,35 Gt Victoriareinblau FGA (C.I. Basic Blue 81) in
100,0 Gt 2-Methoxy-ethanol
wird auf eine 0,3 mm starke, in Salpetersäure elektrochemisch aufgerauhte, in Schwefelsäure anodisierte und mit einer 0,1 %igen wäßrigen Lösung von Polyvinylphosphonsäure nachbehandelte Aluminiumfolie derart aufgebracht, daß ein Trockenschichtgewicht von 1,2 g/m² erhalten wird. Die so erhaltene lichtempfindliche Schicht wird unter einer Standard-Negativvorlage 30 Sekunden mit einer MetallhalogenidLampe von 5 kW Leistung belichtet. Die belichtete Schicht zeigt einen klaren Kontrast zwischen den belichteten und unbelichteten Bereichen. Die Entwicklung erfolgt mit einer Entwicklerlösung folgender Zusammensetzung:
5,0 Gt Natriumoctylsulfat,
1,0 Gt Natriummetasilikat x 5 H₂O,
94,0 Gt dest. Wasser.

Die nichtbelichteten Schichtbereiche werden innerhalb kurzer Zeit saüber entfernt. Die Platte wird anschließend mit Wasser abgespült und getrocknet. In der Kopie werden die feinsten Elemente der Vorlage wiedergegeben. Die derart erhaltenen Druckplatten liefern an einer Bogenoffsetmaschine eine Druckauflage von mehr als 210.000 Bogen.

### Beispiel 2

Eine Beschichtungslösung aus
1,0 Gt des Polymeren L,
1,0 Gt eines Diazoniumsalz-Polykondensationsprodukts wie in Beispiel 1, jedoch isoliert als Methansulfonat,
1,0 Gt eines Diazoniumsalz-Polykondensationsprodukts aus Diphenylamin-4-diazoniumchlorid und Paraformaldehyd, hergestellt in 85 %iger Phosphorsäure und
0,15 Gt Basonyl-Rot 483 (C.I. 45 170) in
23,0 Gt Methanol,
23,0 Gt Propylenglykolmonomethylether und
9,0 Gt dest. Wasser
wird auf eine wie in Beispiel 1 vorbehandelte Aluminiumfolie so aufgebracht, daß ein Trockenschichtgewicht von 0,8 g/m² erhalten wird.

Nach 40 s Belichtung wird die Schicht durch Abspritzen mit einem Wasserstrahl entwickelt, wobei die nicht belichteten Schichtbereiche innerhalb kurzer Zeit saüber entfernt werden, und anschließend getrocknet.

### Beispiel 3

Eine Beschichtungslösung aus
2,6 Gt des Polymeren O,
1,3 Gt des in Beispiel 1 angegebenen Diazoniumsalz-Polykondensationsprodukts,
0,06 Gt Phosphorsäure (85 %ig),
0,02 Gt Metanilgelb (C.I. 13065) und
0,3 Gt Victoriareinblau FGA in
80 Gt 2-Methoxy-ethanol
wird auf eine wie in Beispiel 1 vorbehandelte Aluminiumfolie so aufgebracht, daß ein Trockenschichtgewicht von 0,9 g/m² erhalten wird. Die Schicht wird wie in Beispiel 1 belichtet. Die Entwicklung erfolgt mit einer Entwicklerlösung folgender Zusammensetzung:
5,0 Gt Natriumoctylsulfat,
1,5 Gt Natriummetasilikat x 5 H₂O,
1,0 Gt Trinatriumphosphat x 12 H₂O,
0,5 Gt Dinatriumhydrogenphosphat x 12 H₂O,
92,0 Gt dest. Wasser
durch Überwischen mit einem Plüschtampon. Die nichtbelichteten Stellen werden innerhalb 30 s entfernt. Die Weiterbehandlung erfolgt wie in Beispiel 2. In der Kopie ist die Stufe 4 eines Silberfilm-Halbtonstufenkeils mit einem Dichteumfang von 0,05 bis 3,05 und Dichtestufen von 0,15 voll abgebildet. Auch feinste Raster und Linien der Vorlage werden klar wiedergegeben. Die erhaltene Druckplatte liefert an einer Bogenoffsetmaschine eine Druckauflage von mehr als 195.000 Bogen.

### Beispiel 4

Aus
1,56 Gt des Polymeren K,
0,91 Gt des Diazoniumsalz-Polykondensationsprodukts gemäß Beispiel 1,
0,049 Gt Phosphorsäure (85 %ig),
0,162 Gt 2-(4-Methoxystyryl)-4,6-bis-trichlormethyl-s-triazin,
1,75 Gt eines technischen Gemischs aus Pentaerythrittri- und -tetraacrylat und
0,55 Gt eines Azofarbstoffs, erhalten durch Kuppeln von 2,4-Dinitro-6-chlor-benzoldiazoniumsalz mit 2-Methoxy-5-acetylamino-N-cyanoethyl-N-hydroxyethylanilin in
70,0 Gt Butanon,
4,0 Gt Ethanol und
2,0 Gt Butylacetat
wird eine Lösung hergestellt, die auf den in Beispiel 1 beschriebennen Schichtträger aufgetragen und zu einem Schichtgewicht von 2,1 g/m² getrocknet wird.

Die Schicht wird durch eine Negativvorlage 25 Sekunden belichtet, wobei man eine gedeckte Stufe 4 erhält. Die Entwicklung erfolgt mit einer Entwicklerlösung folgender Zusammensetzung:
5,0 Gt Natriumoctylsulfat,
1,5 Gt Natriummetasilikat x 5 H₂O,
1,0 Gt Trinatriumphosphat x 12 H₂O,
1,0 Gt Phenoxyethanol in
91,5 Gt dest. Wasser.

Nach dem Einspannen der Druckform in eine Druckmaschine nimmt die Druckplatte die angebotene Farbe sehr rasch an. Der Druckversuch wurde bei 220.000 Drucken abgebrochen.

### Beispiel 5

Aus
6,2 Gt des Polymeren M,
2,1 Gt des in Beispiel 1 angegebenen Diazoniumsalz-Polykondensationsprodukts,
0,3 Gt Viktoriareinblau FGA (C.I. Basic Blue 81),
0,24 Gt Phosphorsäure (85 %ig),
0,24 Gt 45 %igem 2,5-Dimethylhexan-2,5-di-tert.-butylperoxid als Granulat mit Kreide (INTEROX DHBP-45-IC/G der Fa. Peroxid-Chemie GmbH) und
0,07 Gt Phenylazodiphenylamin in
257 Gt 2-Methoxy-ethanol und
78 Gt Tetrahydrofuran
wird auf eine wie in Beispiel 1 vorbehandelte Aluminiumfolie aufgebracht und anschließend getrocknet. Die so erhaltene Kopierschicht, die ein Schichtgewicht von 1,1 g/m² aufweist, wird unter einer Negativvorlage 30 Sekunden mit einer Metallhalogenid-Lampe von 5 kW Leistung belichtet. Die belichtete Schicht wird mit dem in Beispiel 4 angegebenen Entwickler mittels eines Plüschtampons behandelt, wobei die nichtbelichteten Schichtbereiche innerhalb von wenigen Sekunden sauber entfernt werden, und anschließend mit Wasser abgespült und getrocknet. In der Kopie ist die Stufe 4 des in Beispiel 3 angegebenen Silberfilm-Halbtonstufenkeils noch voll gedeckt.

Die Druckplatte wird in einem auf 200 °C erhitzten Umlufttrockenschrank 5 Minuten gelagert und anschließend abkühlen gelassen. Nach dem Einspannen in eine Bogenoffsetmaschine wird bei einer Auflage von 260.000 Drucken abgebrochen, obwohl die Platte noch einwandfrei druckt.

### Beispiel 6

Mit dem Polymeren P wird eine Beschichtungslösung wie in Beispiel 1 hergestellt. Die Lösung wird auf Platten aus dem in Beispiel 1 beschriebenen Trägermaterial aufgebracht, so daß ein Trockenschichtgewicht von 1,2 g/m² erhalten wird.

Vier so hergestellte Platten werden 1 bis 4 Stunden in einem Trockenschrank bei 100 °C gelagert. Nach der Wärmebehandlung werden die Platten bildmäßig belichtet und mit dem in Beispiel 4 angegebenen Entwickler entwickelt. Zum Sichtbarmachen von verbleibenden Schichtresten (Ton) in den Nichtbildstellen werden die getrockneten Platten mit Schutzfarbe eingefärbt.

Die eine und zwei Stunden gelagerten Platten lassen sich einwandfrei entwickeln. Sie zeigen keine nennenswerte Verlängerung des Halbtonstufenkeils. Nach dreistündiger Wärmelagerung zeigt die Schicht eine Verlängerung des Halbtonstufenkeils um zwei Stufen. Die Entwicklung ist nur leicht verzögert. Die vier Stunden gelagerte Platte läßt sich etwas verzögert entwickeln. Die Ergebnisse zeigen, daß die erfindungsgemäßen Gemische gegen Lagerung in der Wärme relativ beständig sind.

### Beispiel 7

Eine Beschichtungslösung aus
2,2 Gt des Polymeren Q,
2,2 Gt 4,4′-Diazido-stilben-2,2′-disulfonsäure-Natriumsalz,
0,3 Gt Rhodamin 6 GDN extra (C.I. 45160) und
0,2 Gt 2-Benzoylmethylen-1-methyl-β-naphthothiazolin in
30 Gt Tetrahydrofuran und
120 Gt Wasser
wird auf den in Beispiel 1 beschriebenen Träger so aufgebracht, daß ein Trockenschichtgewicht von 0,9 g/m² erhalten wird. Die Kopierschicht wird 40 Sekunden unter einer Negativvorlage belichtet und anschließend mit reinem Wasser entwickelt, wobei die Nichtbildstellen innerhalb kurzer Zeit entfernt werden.

### Beispiel 8

Aus
2 Gt des Polymeren M,
2,2 Gt des Umsetzungsprodukts aus 1 mol 2,4,4-Trimethyl-hexamethylendiisocyanat und 2 mol Hydroxyethylmethacrylat,
0,15 Gt 2,4-Bis-trichlormethyl-6-(4-styryl-phenyl)-s-triazin und
0,10 Gt des in Beispiel 4 angegebenen Azofarbstoffs in
100 Gt Propylenglykolmonomethylether
wird eine Beschichtungslösung hergestellt, die auf den Träger aus Beispiel 1 zu einem Trockenschichtgewicht von 1,3 g/m² aufgebracht wird. Die Platte wird 25 Sekunden unter einem Halbtonstufenkeil belichtet. Die Entwicklung erfolgt mit dem Entwickler von Beispiel 1. Die rasch entwickelbare Platte zeigt eine gedeckte Stufe 4. Nach dem Einspannen in eine Bogenoffsetmaschine werden 90.000 gute Drucke erhalten.

### Beispiel 9

Aus
2,5 Gt des Polymeren R,
5,6 Gt eines technischen Gemischs aus Pentaerythrittri- und -tetraacrylat,
0,2 Gt des in Beispiel 4 angegebenen Triazins und
0,03 Gt des in Beispiel 4 angegebenen Azofarbstoffs in
25 Gt Butanon,
2 Gt Ethanol und
1 Gt Butylacetat
wird eine Lösung bereitet, die auf eine biaxial verstreckte und thermofixierte Polyethylenterephthalatfolie der Stärke 25 »m so aufgeschleudert wird, daß nach dem Trocknen bei 100 °C ein Trockenschichtgewicht von 35 g/m² erhalten wird. Die derart hergestellte Trockenresistfolie wird mit einer Laminiervorrichtung bei 120 °C auf eine mit 35 »m starker Kupferfolie kaschierte Phenoplast-Schichtstoffplatte laminiert und 25 Sekunden unter einem handelsüblichen Belichtungsgerät belichtet. Als Vorlage dient eine Strichvorlage mit Linienbreiten und Abständen bis herab zu 80 »m. Nach der Belichtung wird die Polyesterfolie langsam abgezogen und die erhaltene Schicht mit einem Entwickler der in Beispiel 1 angegebenen Zusammensetzung in einem Sprühentwicklungsgerät 90 Sekunden entwickelt. Anschließend wird 30 Sekunden mit Leitungswasser gespült, 30 Sekunden in einer 15 %igen Ammoniumperoxydisulfatlösung angeätzt und anschließend in folgenden Elektrolytbädern galvanisiert:
1. 30 Minuten in einem Kupferbad der Fa. Schlötter, Geislingen/Steige, Typ "Glanzkupfer-Bad".
   Stromdichte: 2,5 A/cm^{2.}
   Metallaufbau: ca. 12,5 »m.
2. 30 Minuten in einem Nickelbad des gleichen Herstellers, Typ "Norma".
   Stromdichte: 4,0 A/cm².
   Metallaufbau: 9 »m.

Die Platte zeigt keine Beschädigungen oder Unterwanderungen. Die Entschichtung erfolgt in 5-%iger KOH-Lösung bei 50 °C. Das freigelegte Kupfer wird mit den üblichen Ätzmedien weggeätzt.

### Beispiel 10

Eine Beschichtungslösung aus
1,0 Gt des Polymeren S,
1,0 Gt eines technischen Gemischs aus Pentaerythrit-tri- und -tetraacrylat,
0,10 Gt 2-(4-Trichlormethyl-benzoylmethylen)-3-ethyl-benzthiazolin und
0,02 Gt Victoriareinblau FGA (C.I. Basic Blue 81) in
50,0 Gt Propylenglykolmonomethylether
wird auf eine elektrochemisch aufgerauhte, anodisierte und mit Polyvinylphosphonsäure nachbehandelte Aluminiumfolie aufgetragen und zu einem Schichtgewicht von 1,3 g/m² getrocknet. Die erhaltene Druckplatte wird unter einer Testvorlage belichtet und mit dem in Beispiel 1 angegebenen Entwickler entwickelt.

Die Druckform nimmt in der Bogenoffsetmaschine sofort fette Farbe an. Auch nach längerem Maschinenstillstand wird die Farbe bereits nach 2 bis 8 Bögen wieder voll angenommen. Die erzielte Druckauflage beträgt 95.000 einwandfreie Drucke, wobei auch feinste Linien noch voll wiedergegeben werden.

### Beispiel 11

Eine Beschichtungslösung aus
1,0 Gt des Polymeren T,
1,0 Gt Pentaerythrittriacrylat,
0,1 Gt des in Beispiel 8 angegebenen Triazins und
0,03 Gt Victoriareinblau FGA in
50,0 Gt Propylenglykolmonomethylether
wird auf den Träger aus Beispiel 1 so aufgebracht, daß ein Trockenschichtgewicht von 1,1 g/m² erhalten wird. Die lichtempfindliche Schicht wird unter einer Standard-Negativvorlage 30 Sekunden mit einer Metallhalogenid-Lampe von 5 kW Leistung belichtet und mit der Entwicklerlösung aus Beispiel 1 entwickelt. In der Kopie ist die Stufe 4 des Stufenkeils voll abgebildet. Auch feinste Raster und Linien der Vorlage werden klar wiedergegeben. Die Platte liefert an einer Bogenoffsetmaschine 65.000 gute Drucke.

### Beispiel 12

Die im Beispiel 11 hergestellte Druckplatte wird zum Schutz der Oberfläche mit einer 0,5 »m starken Schicht von Polyvinylalkohol (12 % Restacetylgruppen, K-Wert 4) überzogen. Die Platte wird unter einer Standardnegativvorlage 5 Sekunden belichtet und mit dem in Beispiel 1 beschriebenen Entwickler entwickelt. Sie zeigt eine gedeckte Stufe 4 und liefert an einer Bogenoffsetdruckmaschine 185.000 gute Drucke.

Dieses Beispiel zeigt, daß durch Aufbringen einer Sauerstoff-Sperrschicht auf die photohärtbare Schicht sowohl eine Steigerung der Lichtempfindlichkeit als auch eine Erhöhung der Druckauflage erreicht werden kann. Andererseits geht aus dem Vergleich der Beispiele 11 und 12 hervor, daß auch ohne Deckschicht bereits eine Druckplatte mit hervorragender Druckauflage erhalten werden kann.

### Beispiel 13

Die in Beispiel 11 hergestellte Druckplatte wird nach dem Belichten eine Minute bei 100 °C behandelt und anschließend entwickelt. Im Vergleich zu der nicht nacherwärmten Druckplatte aus Beispiel 11 werden zwei gedeckte Stufen mehr erhalten.

Die Druckauflage kann durch die Nacherwärmung verdreifacht werden. Dieselbe Steigerung der Auflagenbeständigkeit kann durch Nachbelichten erreicht werden.

| Nachbehandlung | Druckauflage |
|---|---|
| ohne | 50.000 |
| 1 Minute 100 °C | 151.000 |
| 1 Minute Nachbelichten (5 kW) | 156.000 |
| 30 Sekunden Nachbelichten (5 kW) | 150.000 |

## Patentansprüche

1. Lichtempfindliches Gemisch, das als wesentliche Bestandteile eine lichthärtbare Verbindung oder Verbindungskombination und ein polymeres Bindemittel mit wiederkehrenden Vinylacetaleinheiten enthält, dadurch gekennzeichnet, daß das Bindemittel ein Pfropfmischpolymerisat mit einem Polyurethan als Pfropfgrundlage ist, das aufgepfropfte Ketten mit Vinylalkoholeinheiten und von Hydroxyaldehyden abgeleiteten Vinylacetaleinheiten trägt.

2. Lichtempfindliches Gemisch nach Anspruch 1, dadurch gekennzeichnet, daß die aufgepfropften Ketten ferner Vinylestereinheiten enthalten.

3. Lichtempfindliches Gemisch nach Anspruch 1, dadurch gekennzeichnet, daß die Vinylacetaleinheiten von einem aliphatischen oder cycloaliphatischen Hydroxyaldehyd abgeleitet sind.

4. Lichtempfindliches Gemisch nach Anspruch 1, dadurch gekennzeichnet, daß die aufgepfropften Ketten ferner Vinylacetaleinheiten enthalten, die keine freien Hydroxygruppen enthalten.

5. Lichtempfindliches Gemisch nach Anspruch 1, dadurch gekennzeichnet, daß das Polyurethan ein Polyadditionsprodukt aus Diisocyanaten und Diolen ist.

6. Lichtempfindliches Gemisch nach Anspruch 5, dadurch gekennzeichnet, daß als Diol ein aliphatisches Diol mit 2 bis 12 Kohlenstoffatomen, ein cycloaliphatisches Diol mit 5 bis 10 Kohlenstoffatomen oder ein aliphatisches Polydiol mit einem Molekulargewicht von 200 bis 10.000 eingesetzt wird.

7. Lichtempfindliches Gemisch nach Anspruch 6, dadurch gekennzeichnet, daß als Diol ein Gemisch aus 1 mol Polydiol und 0,1 bis 0,7 mol niedermolekularem aliphatischem Diol eingesetzt wird.

8. Lichtempfindliches Gemisch nach Anspruch 5, dadurch gekennzeichnet, daß das Diisocyanat ein aliphatisches Diisocyanat mit 4 bis 15 Kohlenstoffatomen oder ein cycloaliphatisches Diisocyanat mit 7 bis 15 Kohlenstoffatomen ist.

9. Lichtempfindliches Gemisch nach Anspruch 1, dadurch gekennzeichnet, daß das Pfropfpolymerisat eine Hydroxylzahl im Bereich von 100 bis 800 aufweist.

10. Lichtempfindliches Gemisch nach Anspruch 1, dadurch gekennzeichnet, daß die lichthärtbare Verbindung ein Diazoniumsalz-Polykondensationsprodukt ist.

11. Lichtempfindliches Gemisch nach Anspruch 10, dadurch gekennzeichnet, daß das Diazoniumsalz-Polykondensationsprodukt aus wiederkehrenden Einheiten A-N₂X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

12. Lichtempfindliches Gemisch nach Anspruch 1, dadurch gekennzeichnet, daß die lichthärtbare Verbindung eine organische Azidoverbindung ist.

13. Lichtempfindliches Gemisch nach Anspruch 12, dadurch gekennzeichnet, daß die organische Azidoverbindung mindestens zwei Azidogruppen im Molekül enthält.

14. Lichtempfindliches Gemisch nach Anspruch 1, dadurch gekennzeichnet, daß die lichthärtbare Verbindungskombination ein photopolymerisierbares Gemisch aus einer radikalisch polymerisierbaren Verbindung mit mindestens einer endständigen ethylenisch ungesättigten Gruppe und einem Siedepunkt bei Normaldruck oberhalb 100 °C und einer Verbindung oder einer Verbindungskombination ist, die unter Einwirkung von aktinischem Licht die Polymerisation der radikalisch polymerisierbaren Verbindung einzuleiten vermag.

15. Lichtempfindliches Gemisch nach Anspruch 14, dadurch gekennzeichnet, daß die radikalisch polymerisierbare Verbindung ein Acryl- oder Methacrylsäureester eines ein- oder mehrwertigen Alkohols oder ein Acryl- oder Methacrylsäureamid ist.

16. Lichtempfindliches Gemisch nach Anspruch 14, dadurch gekennzeichnet, daß es zusätzlich ein Diazoniumsalz-Polykondensationsprodukt enthält.

17. Lichtempfindliches Gemisch nach Anspruch 1, dadurch gekennzeichnet, daß es 20 bis 95 Gew.-% Pfropfmischpolymerisat und 5 bis 80 Gew.-% lichthärtbare Verbindungen bzw. Verbindungskombinationen enthält.

18. Lichtempfindliches Aufzeichnungsmaterial mit einem Schichtträger und einer lichtempfindlichen Schicht, dadurch gekennzeichnet, daß die lichtempfindliche Schicht aus einem Gemisch gemäß einem der Ansprüche 1 bis 17 besteht.

## Claims

1. A photosensitive mixture which contains, as essential constituents, a photocurable compound or combination of compounds and a polymeric binder with repeating vinylacetal units, wherein said binder is a graft copolymer obtained from a polyurethane graft backbone, onto which chains containing vinyl alcohol units and vinyl acetal units derived from hydroxyaldehydes are grafted.

2. The photosensitive mixture as claimed in claim 1, wherein the grafted-on chains furthermore contain vinyl ester units.

3. The photosensitive mixture as claimed in claim 1, wherein the vinyl acetal units are derived from an aliphatic or cycloaliphatic hydroxyaldehyde.

4. The photosensitive mixture as claimed in claim 1, wherein the grafted-on chains furthermore contain vinyl acetal units containing no free hydroxyl groups.

5. The photosensitive mixture as claimed in claim 1, wherein the polyurethane is a polyaddition product obtained from diisocyanates and diols.

6. The photosensitive mixture as claimed in claim 5, wherein the diol is an aliphatic diol having 2 to 12 carbon atoms, a cycloaliphatic diol having 5 to 10 carbon atoms or an aliphatic polydiol having a molecular weight between 200 and 10,000.

7. The photosensitive mixture as claimed in claim 6, wherein the diol is a mixture comprising 1 mol of polydiol and 0.1 to 0.7 mol of low molecular weight aliphatic diol.

8. The photosensitive mixture as claimed in claim 5, wherein the diisocyanate is an aliphatic diisocyanate having 4 to 15 carbon atoms or a cycloaliphatic diisocyanate having 7 to 15 carbon atoms.

9. The photosensitive mixture as claimed in claim 1, wherein the graft polymer has a hydroxyl number in the range of 100 to 800.

10. The photosensitive mixture as claimed in claim 1, wherein the photocurable compound is a diazonium salt polycondensation product.

11. The photosensitive mixture as claimed in claim 10, wherein the diazonium salt polycondensation product comprises recurrent units A-N₂X and B, which are linked by intermediate members, preferably methylene groups, which are derived from condensible carbonyl compounds, with A being the radical of an aromatic diazonium compound which is capable of condensation with formaldehyade and B being the radical of a compound which is free of diazonium groups and is capable of condensation with formaldehyde, particularly of an aromatic amine, of a phenol, of a phenol ether, of an aromatic thioether, of an aromatic hydrocarbon, of an aromatic heterocyclic compound or of an organic acid amide.

12. The photosensitive mixture as claimed in claim 1, wherein the photocurable compound is an organic azido compound.

13. The photosensitive mixture as claimed in claim 12, wherein the organic azido compound includes at least two azido groups in its molecule.

14. The photosensitive mixture as claimed in claim 1, wherein the photocurable combination of compounds is a photopolymerizable mixture comprising a free-radically polymerizable compound possessing at least one terminal ethylenically unsaturated group and having a boiling point of more than 100 °C at normal pressure, and a compound or a combination of compounds which under the action of actinic light is capable of initiating the polymerization of the free-radically polymerizable compound.

15. The photosensitive mixture as claimed in claim 14, wherein the compound which can be polymerized by a free-radical process is an acrylate or methacrylate of a mono- or polyhydric alcohol or an acrylic or methacrylic acid amide.

16. The photosensitive mixture as claimed in claim 14, wherein a diazonium salt polycondensation product is additionally contained.

17. The photosensitive mixture as claimed in claim 1, wherein 20 to 95 % by weight of graft copolymer and 5 to 80 % by weight of photocurable compounds or combinations of compounds are contained

18. A photosensitive recording material comprising a layer support and a photosensitive layer, wherein the photosensitive layer comprises a mixture as claimed in any of claims 1 to 17.

## Revendications

1. Composition photosensible qui contient, en tant que composants essentiels, un composé photodurcissable ou une association de composés photodurcissable et un liant polymère à motifs répétitifs acétal de vinyle, caractérisée en ce que le liant est un copolymère greffé comportant un polyuréthanne en tant que support de greffe, qui porte des chaînes greffées de motifs alcool de vinyle et de motifs acétal de vinyle dérivés d'hydroxyaldéhydes.

2. Composition photosensible selon la revendication 1, caractérisée en ce que les chaînes greffées contiennent en outre des motifs ester vinylique.

3. Composition photosensible selon la revendication 1, caractérisée en ce que les motifs acétal de vinyle sont dérivés d'un hydroxyaldéhyde aliphatique ou cycloaliphatique.

4. Composition photosensible selon la revendication 1, caractérisée en ce que les chaînes greffées contiennent en outre des motifs acétal de vinyle qui ne contiennent pas de groupes hydroxy libres.

5. Composition photosensible selon la revendication 1, caractérisée en ce que le polyuréthanne est un produit de polyaddition de diisocyanates et de diols.

6. Composition photosensible selon la revendication 5, caractérisée en ce que, en tant que diol, on utilise un diol aliphatique ayant de 2 à 12 atomes de carbone, un diol cycloaliphatique ayant de 5 à 10 atomes de carbone ou un polydiol aliphatique ayant une masse moléculaire de 200 à 10 000.

7. Composition photosensible selon la revendication 6, caractérisée en ce que, en tant que diol, on utilise un mélange de 1 mole de polydiol et de 0,1 à 0,7 mole d'un diol aliphatique à faible masse moléculaire.

8. Composition photosensible selon la revendication 5, caractérisée en ce que le diisocyanate est un diisocyanate aliphatique ayant de 4 à 15 atomes de carbone ou un diisocyanate cycloaliphatique ayant de 7 à 15 atomes de carbone.

9. Composition photosensible selon la revendication 1, caractérisée en ce que le polymère greffé présente un indice d'hydroxy dans la plage de 100 à 800.

10. Composition photosensible selon la revendication 1, caractérisée en ce que le composé photodurcissable est un produit de polycondensation de sel de diazonium.

11. Composition photosensible selon la revendication 10, caractérisée en ce que le produit de polycondensation de sel de diazonium consiste en motifs répétitifs A-N₂X et B, qui sont liés les uns aux autres par des chaînons intermédiaires, de préférence des groupes méthylène, et qui sont dérivés de composés carbonyle condensables, A étant le reste d'un composé diazonium aromatique condensable avec le formaldéhyds et B étant le reste d'un composé exempt de groupes diazonium et condensable avec le formaldéhyde, en particulier d'une amine aromatique, d'un phénol, d'un phénoléther, d'un thioéther aromatique, d'un hydrocarbure aromatique, d'un composé hétérocyclique aromatique ou d'un amide organique.

12. Composition photosensible selon la revendication 1, caractérisée en ce que le composé photodurcissable est un composé azido organique.

13. Composition photosensible selon la revendication 12, caractérisée en ce que le composé azido organique contient au moins 2 groupes azido dans sa molécule.

14. Composition photosensible selon la revendication 1, caractérisée en ce que l'association de composés photodurcissable est un mélange photopolymérisable d'un composé apte à la polymérisation radicalaire, comportant au moins un groupe terminal à insaturation éthylénique et ayant un point d'ébullition supérieur à 100°C sous la pression normale, et d'un composé ou d'une association de composés, permettant l'amorçage, sous l'effet d'une lumière actinique, de la polymérisation du composé apte à la polymérisation radicalaire.

15. Composition photosensible selon la revendication 14, caractérisée en ce que le composé apte à la polymérisation radicalaire est un ester acrylique ou méthacrylique d'un alcool mono- ou polyhydroxylé, ou un acrylamide ou méthacrylamide.

16. Composition photosensible selon la revendication 14, caractérisée en ce qu'elle contient en outre un produit de polycondensation de sel de diazonium.

17. Composition photosensible selon la revendication 1, caractérisée en ce qu'elle contient de 20 à 95 % en poids d'un copolymère greffé et de 5 à 80 % en poids de composés photodurcissables ou d'associations de composés photodurcissables.

18. Matériau de reprographie photosensible, comportant un support de couche et une couche photosensible, caractérisé en ce que la couche photosensible consiste en une composition selon l'une des revendications 1 à 17.
